# EUROPEAN PATENT APPLICATION

(11) **EP 4 521 129 A1**
(43) Date of publication of application: **12.03.2025**
(21) Application number: 23799664.0
(22) Date of filing: 03.05.2023
(51) Int. Cl.: G01R 31/385, G01R 31/364, G01R 31/36, H02J 7/00

(54) **SYSTEM FOR TESTING CHARGING AND DISCHARGING OF BATTERY MODULE, AND METHOD THEREFOR**

(30) Priority: 03.05.2022 KR 20220054492
(71) Applicant: LG Energy Solution, Ltd., Seoul 07335 (KR)
(72) Inventor: HYUN, Jae Jin, Daejeon 34122 (KR)
(74) Representative: Goddar, Heinz J.
(86) International application number: PCT/KR2023/006006
(87) International publication number: WO 2023/214783

(57) **Abstract**

An aspect of the current disclosure includes a battery module charge and discharge inspection system. The battery module charge and discharge inspection system may include a supporting member configured to support a battery module and transfer the battery module, a first fixing member provided on a top of one side of the supporting member, a second fixing member provided at a bottom of one side of the supporting member, a connecting pin disposed to pass through the first fixing member, the supporting member, and the second fixing member, respectively, and a charge and discharge inspection part configured to inspect whether or not the battery module is abnormal through charging and discharging of the battery module. The first fixing member may be configured to be connected to a first wire harness extending from the battery module.

## Description

### Technical Field

The present invention relates to a battery module charge and discharge inspection system and a method thereof, which relates to an inspection system capable of performing charge and discharge inspection of a battery module stably and efficiently, and a method thereof.

This application claims the benefit of priority based on Korean Patent Application No. 10-2022-0054492 dated May 3, 2022, the disclosure of which is incorporated herein by reference in its entirety.

### Background Art

In general, a battery module is provided with a plurality of wires electrically connected to the secondary battery. These wires are usually provided in the form of wire harnesses including connectors.

Here, the connector can make an electrical connection with an external device so that it can provide electrical energy generated in the battery module to the external device, and can also be electrically connected to a charge and discharge inspection device, during the battery module manufacturing process, in order to detect the characteristics of the secondary battery, such as battery module charging and discharging.

Currently, in the battery module charge and discharge inspection system, an operator manually connects a battery module and a charge and discharge inspection part using a wire harness part to perform an inspection process. As a result, there was a problem that the wire harness part moved during the inspection process, and a lot of time was required for the inspection process by the manual task.

In addition, after a coupling process of forming a wire harness and connecting it to the battery module is performed, the battery module is then transferred to the inspection process. At this instance, there is a concern that the wire harness is damaged due to the flow of the wire harness.

Therefore, there is a need for a battery module charge and discharge inspection system to solve these problems.

### Disclosure

### Technical Problem

The present invention is intended to solve the conventional problems.

Through one example of the present invention, it is intended to provide a charge and discharge inspection system capable of suppressing flowage of a wire harness in a battery module and performing an automatic charge and discharge inspection through labor saving.

According to one example of the present invention, it is intended to provide a charge and discharge inspection system capable of preventing damage to a wire harness due to the flowage of the wire harness in a process of transferring a battery module, and a method thereof, and a battery module transfer pallet.

### Technical Solution

In order to achieve the above-described objects, according to an aspect of the current disclosure, a battery module charge and discharge inspection system may be provided, including a supporting member configured to support a battery module and transfer the battery module, a first fixing member provided on a top of one side of the supporting member, a second fixing member provided at a bottom of one side of the supporting member, a connecting pin disposed to pass through the first fixing member, the supporting member, and the second fixing member, respectively, and a charge and discharge inspection part configured to inspect whether or not the battery module is abnormal through charging and discharging of the battery module, wherein the first fixing member is configured to be connected to a first wire harness extending from the battery module, and wherein the second fixing member is configured to be connected to a second wire harness extending from the charge and discharge inspection part.

The first fixing member and the second fixing member may be provided so as to face each other vertically in a thickness direction of the supporting member.

The connecting pin may extend along a laminating direction of the first fixing member, the supporting member, and the second fixing member, and an extension length of the connecting pin is greater than a total combined thickness of the first fixing member, the supporting member, and the second fixing member.

The battery module charge and discharge inspection system may further include a current applying part configured to apply a current while being in contact with a terminal block of the battery module.

The terminal block may include a positive electrode and a negative electrode.

A connection between the current applying part and the terminal block and a connection between the second fixing member and the charge and discharge inspection part may be automatically performed.

The battery module charge and discharge inspection system may further include a plurality of battery cells.

The battery cell may be a secondary battery.

The first wire harness may include a first connector inserted into an insertion part of the battery module, a second connector coupled to the first fixing member and configured to be electrically connected to the connecting pin, and a first connection part configured to connect the first connector and the second connector.

The first connection part may be ductile.

Another aspect of the current disclosure includes a battery module charge and discharge inspection method including a coupling process of forming a first wire harness and connecting a battery module seated in a fixing part and the first wire harness, and an inspection process of performing a charge and discharge inspection of the battery module transferred through the fixing part, wherein the fixing part includes a supporting member configured to support the battery module and transfer the battery module, a first fixing member provided on a top of one side of the supporting member, a second fixing member provided at a bottom of one side of the supporting member, and a connecting pin disposed to pass through the first fixing member, the supporting member, and the second fixing member, respectively, wherein the first fixing member in the coupling process is connected to the first wire harness extending from the battery module, and wherein the second fixing member in the inspection process is connected to a charge and discharge inspection part.

A second wire harness extending from the charge and discharge inspection part may be included, the second fixing member is coupled to the second wire harness in the inspection process.

The first wire harness may include a first connection part that is ductile, wherein a connection between the first wire harness and the first fixing member in the coupling process is manually performed, and wherein a connection between the charge and discharge inspection part and the second fixing member in the inspection process is automatically performed.

In the inspection process, a current may be applied to the battery module by connecting a current applying part to a terminal block of the battery module.

In the inspection process, a connection between the terminal block and the current applying part is automatically performed.

Another aspect of the current disclosure may include a pallet for manufacturing a secondary battery, supporting a secondary battery module and provided to transfer the battery module between processes including a supporting member configured to support the battery module, a first fixing member provided on a top of one side of the supporting member, a second fixing member provided at a bottom of one side of the supporting member, and a connecting pin disposed to pass through the first fixing member, the supporting member, and the second fixing member, respectively, wherein in a coupling process in which a first wire harness is formed and coupled, the first fixing member is configured to be connected to the first wire harness extending from the battery module, and in a charge and discharge inspection process performed after the coupling process, the second fixing member is configured to be connected to a second wire harness extending from a charge and discharge inspection part.

### Advantageous Effects

Through one example of the present invention, it is possible to provide a charge and discharge inspection system capable of suppressing flowage of a wire harness in a battery module and performing an automatic charge and discharge inspection through labor saving, and a method thereof.

Through one example of the present invention, in a process of transferring a battery module, it is possible to provide a charge and discharge inspection system capable of preventing damage to a wire harness due to the flowage of the wire harness, and a method thereof.

Through one example of the present invention, in a subsequent process of connecting a wire harness to a battery module, it is possible to provide a transfer pallet for manufacturing a secondary battery capable of suppressing the flowage of the wire harness to prevent damage to the wire harness in the subsequent process.

### Description of Drawings

Figure 1 is a diagram exemplarily showing a battery module charge and discharge inspection system according to one example of the present application.
Figure 2 is a diagram exemplarily showing a first side of a battery module according to one example of the present application.
Figure 3 is a diagram exemplarily shown to explain a process of connecting a first wire harness to an insertion part of a battery module according to one example of the present application.
Figure 4 is a diagram exemplarily shown to explain a process of connecting a first wire harness to a connecting pin of a fixing part according to one example of the present application.
Figure 5 is a diagram exemplarily shown to explain a process of contacting a current applying part to a terminal block of a battery module according to one example of the present application.

### Best Mode

Hereinafter, the battery module charge and discharge inspection system of the present application will be described with reference to the accompanying drawings, and the accompanying drawings are exemplary, and the battery module charge and discharge inspection system of the present application is not limited to the accompanying drawings.

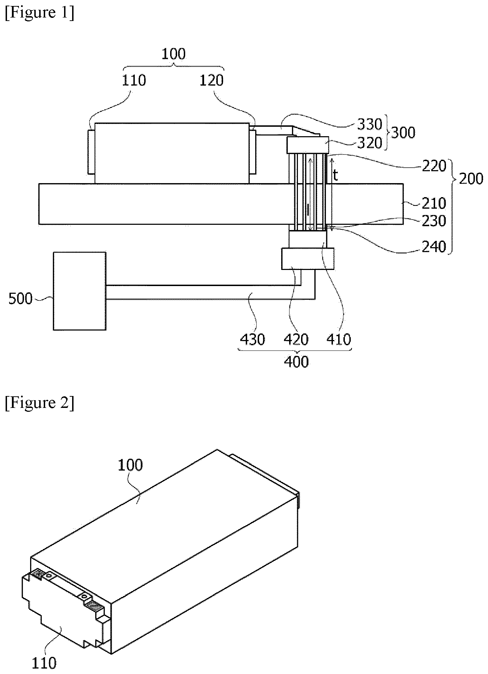

Figure 1 is a diagram exemplarily showing a battery module charge and discharge inspection system according to one example of the present application.

As shown in Figure 1, the battery module charge and discharge inspection system of the present application may be formed by comprising a fixing part (200) and a charge and discharge inspection part (500).

The fixing part (200) is supports a battery module (100), which may be, preferably, provided to support the battery module (100) from a previous process as well as an inspection process for a charge and discharge inspection. That is, in a coupling process of connecting a first wire harness part (300) to the battery module (100), the fixing part (200) may support the battery module (100), and the fixing part (200) may be provided to transfer the battery module (100) to a subsequent inspection process.

The fixing part (200) may perform a role of fixing the first wire harness part (300) as well as transferring/supporting the battery module (100) unlike a general transfer pallet for manufacturing a secondary battery. That is, in the first wire harness part (300) having one end connected to the battery module (100) and the other end formed as a free end, the fixing part (200) may be coupled to the other end to perform a role of fixing the entire first wire harness part (300).

The battery module (100) may be formed by comprising a terminal block (110) provided on a first side and an insertion part (120) provided on a second side facing the first side. That is, the battery module is formed, as one example, in a rectangular parallelepiped shape, where the terminal block (100) and the insertion part (120) may be provided on the first side and the second side provided at both ends in the longitudinal direction.

The battery module (100) is a battery assembly that battery cells are bundled in a certain number and inserted into a frame to protect them from external shocks, heat, vibration, and the like, which comprises the terminal block (110) and the insertion part (120) as described above.

The terminal block (110) is a part to which a current applying part for applying a current to the battery module (100) is electrically connected, which is provided on a first side of the battery module (100). By applying a current to the battery module (100) through the terminal block (110), the charge and discharge of the battery module (100) may be performed. In this specification, the "first side" means any one side.

Figure 2 is a diagram exemplarily showing a first side of a battery module according to one example of the present application.

As shown in Figure 2, the terminal block (110) may be composed of a pair of positive (+) and negative (-) electrodes. Through this, the current applying part may apply a current to the battery module (100) by performing the electrical contact with the positive electrode (+) and the negative electrode (-) of the terminal block (110), respectively. As the terminal block (110) is composed of a pair of positive (+) and negative (-) electrodes, it may apply the current for performing the charge and discharge of the battery module to the battery module (100) by performing the above-described contact through the current applying part.

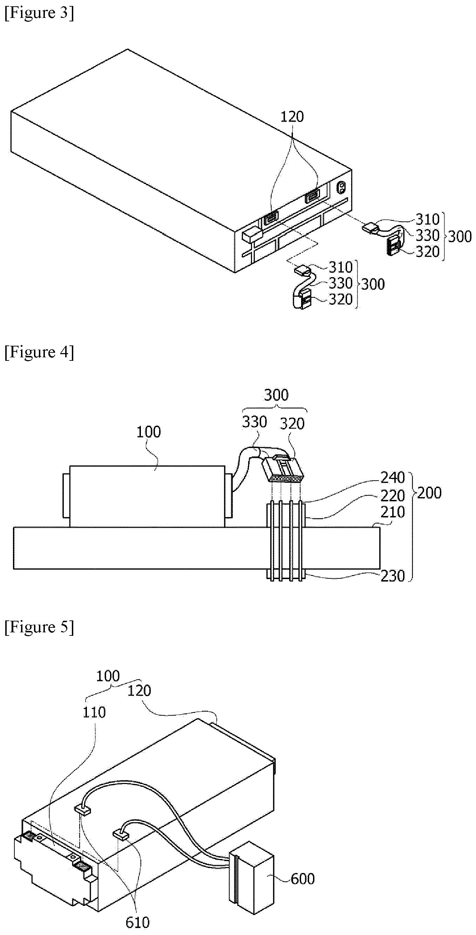

In addition, as shown in Figures 1 and 3, the insertion part (120) is a part where the first wire harness part (300) is inserted so that the charge and discharge inspection part (500) is electrically connected to the battery module (100), which may be provided on a second side facing the first side. In this specification, the "second side facing the first side" means the other side, different from the first side, provided at a position facing the first side.

In one example, the battery module (100) may comprise a plurality of battery cells. In this specification, the term "plurality" means two or more, the upper limit of which is not particularly limited.

For example, the battery cell may be a secondary battery. Specifically, the secondary battery is a battery that can be used by charging and discharging electrical energy. For example, the secondary battery may be a lithium secondary battery. The lithium secondary battery may be manufactured by mounting an electrode assembly, in which a positive electrode (cathode), a separator, and a negative electrode (anode) are laminated, in a pouch. The lithium secondary battery may be charged and discharged while repeating processes of intercalation and deintercalation of lithium ions from the lithium metal oxide of the positive electrode to the negative electrode.

The first wire harness (300) may be referred to as a cable module for connecting the battery module (100) and an external device. That is, it may be referred to as a module for electrically connecting the battery module (100) and an external device. The first wire harness (300) may be provided to be electrically connected to a charge and discharge inspection part for the charge and discharge inspection. That is, in the charge and discharge inspection process, the external device may be referred to as a charge and discharge inspection part.

The first wire harness part (300) may comprise a first connector (310), a second connector (320), and a first connection part (330) connecting them.

The first connector (310) is a connection instrument for electrically connecting the battery module (100) and the first connection part (330), which is connected to one end of the first connection part (330) to be inserted into and connected to the insertion part (120) of the battery module (100). In this specification, the "one end" means any one end.

Figure 3 is a diagram exemplarily shown to explain a process of connecting a first wire harness to an insertion part of a battery module according to one example of the present application. As shown in Figure 3, the first wire harness part (300) may be connected to the battery module (100) as the first connector (310) is connected to the insertion part (120).

The second connector (320) is a connection instrument for electrically connecting the fixing part (200) and the first connection part (330), which may be connected to the other end of the first connection part (330) to be connected to the connecting pin (240) disposed to pass through the first fixing member (220) of the fixing part (200). In this specification, "the other end" means any one end other than one end, that is, the other end.

The first connection part (330) is a part that electrically connects the first connector (310) and the second connector (320), where the first connector (310) and the second connector (320) are electrically connected to both ends, respectively. The flowage is suppressed as the first connector (310) and the second connector (320) as described above are fixed to the connection part (330), whereby the automatic charge and discharge inspection through labor saving is possible, and thus the work time may be shortened.

In one example, the first connection part (330) may have ductility. As the first connection part (330) has ductility, there may be a problem that the operator has to manually connect the second connector (320) and the third connector (410), but the second connector (320) is fixed by the fixing part (200), specifically, the connecting pin (240) and the flowage is suppressed, whereby the automatic charge and discharge inspection is possible through labor saving, and thus the work time may be shortened.

Generally, in the conventional coupling process, the assembly of the first wire harness part and the connection between the insertion part (120) and the first connector (310) were manually performed, and in this coupling process, the second connector (320) was left at its free end, so that the entire first wire harness flowed, whereby there was a risk of damage to the first wire harness upon moving to a subsequent process or upon the subsequent process.

In order to solve this problem, according to one example of the present invention, it is possible to form on the fixing part (200) a first fixing member (220) to which the second connector (320) of the first wire harness part (300) can be fixed and coupled.

The fixing part (200) supports the battery module (100) and fixes the first wire harness part (300) and the second wire harness part (400) by electrically connecting them, which may comprise the supporting member (210), the first fixing member (220), the second fixing member (230) and the connecting pin (240). As the charge and discharge inspection system of the battery module (100) comprises the fixing part (200) having the first fixing member (220), the flowage of the first wire harness part (300) is suppressed, whereby the automatic charge and discharge inspection is possible through labor saving, and thus the work time may be shortened.

The supporting member (210) is a member that supports the battery module (100), specifically, supports the battery module (100) and the first fixing member (220), and moves the battery module by seating it during a process.

In one example, the supporting member (210) may have a first groove (not shown) provided so that the connecting pin (240) is fixed by passing through it. The supporting member (210) may maintain the connecting pin in a fixed state by having the above-described first groove. As a result, during the charge and discharge inspection of the battery module (100), the flowage of the first wire harness part (300) inserted into the connecting pin is suppressed, whereby the automatic charge and discharge inspection is possible through labor saving, and thus the work time may be shortened.

Also, there may be a plurality of first grooves, which may be provided at a position where the first fixing member (220) of the supporting member (210) is disposed. At this time, the number of the plurality of first grooves is not particularly limited if it is greater than or equal to the number of the plurality of connecting pins (240) to be described below.

In addition, the size of the first groove, specifically, the diameter of one first groove may be the same as the diameter of one connecting pin, and the specific size is not particularly limited. As the diameter of the first groove is the same as the diameter of the connecting pin (240), the connecting pin (240) is inserted into the first groove and maintained in a fixed state, and during the charge and discharge inspection of the battery module (100), the flowage of the first wire harness part (300) inserted into the connecting pin (240) is suppressed, whereby the automatic charge and discharge inspection is possible through labor saving, and thus the work time may be shortened. In this specification, the "diameter of the connecting pin" may mean the diameter of the cross-sectional area inserted into the first groove.

The first fixing member (220) is a member fixing the connecting pin (240), which may have a separation distance from the battery module (100) and may be disposed on the top of the supporting member (210). As the connecting pin (240) is fixed through the first fixing member (220), the flowage of the first wire harness part (300) is suppressed during the charge and discharge inspection of the battery module (100), whereby the automatic charge and discharge inspection is possible through labor saving, and thus the work time may be shortened.

In one example, the first fixing member (220) may have a second groove (not shown) provided so that the connecting pin (240) is fixed by passing through it. The first fixing member (220) may maintain the connecting pin (240) in a fixed state by having the above-described second groove. As a result, during the charge and discharge inspection of the battery module (100), the flowage of the first wire harness part (300) inserted into the connecting pin (240) is suppressed, whereby the automatic charge and discharge inspection is possible through labor saving, and thus the work time may be shortened.

Also, there may be a plurality of second grooves, which may be provided at a position coincident with the position where the first groove of the supporting member (210) is disposed. At this time, the number of the plurality of second grooves is not particularly limited if it is greater than or equal to the number of the plurality of connecting pins (240) to be described below.

In addition, the size of the second groove, specifically, the diameter of one second groove may be the same as the diameter of one connecting pin, and the specific size is not particularly limited. As the diameter of the second groove is the same as the diameter of the connecting pin (240), the connecting pin (240) is inserted into the second groove and maintained in a fixed state, and during the charge and discharge inspection of the battery module (100), the flowage of the first wire harness part (300) inserted into the connecting pin (240) is suppressed, whereby the automatic charge and discharge inspection is possible through labor saving, and thus the work time may be shortened.

Furthermore, the first fixing member (220) is not particularly limited if the area in contact with the supporting member (210) is greater than the size of the first groove, specifically, the combined size of the circular areas of the plurality of first grooves.

The second fixing member (230) is a member fixing the connecting pin (240), which is disposed at the bottom of the supporting member (210). As the connecting pin (240) is fixed through the second fixing member (230), the flowage of the first wire harness part (300) is suppressed during the charge and discharge test of the battery module (100), whereby the automatic charge and discharge inspection is possible through labor saving, and thus the work time may be shortened.

In one example, the second fixing member (230) may have a third groove (not shown) provided so that the connecting pin (240) is fixed by passing through it. The second fixing member (230) may maintain the connecting pin (240) in a fixed state by having the above-described third groove. As a result, during the charge and discharge inspection of the battery module (100), the flowage of the first wire harness part (300) inserted into the connecting pin (240) is suppressed, whereby the automatic charge and discharge inspection is possible through labor saving, and thus the work time may be shortened.

Also, there may be a plurality of third grooves, which may be provided at a position coincident with the position where the first groove of the supporting member (210) is disposed. At this time, the number of the plurality of third grooves is not particularly limited if it is greater than or equal to the number of the plurality of connecting pins (240) to be described below.

In addition, the size of the third groove, specifically, the diameter of one third groove may be the same as the diameter of one connecting pin, and the specific size is not particularly limited. As the diameter of the third groove is the same as the diameter of the connecting pin (240), the connecting pin (240) is inserted into the third groove and maintained in a fixed state, and during the charge and discharge inspection of the battery module (100), the flowage of the first wire harness part (300) inserted into the connecting pin (240) is suppressed, whereby the automatic charge and discharge inspection is possible through labor saving, and thus the work time may be shortened.

The second fixing member (220) is not particularly limited if the area in contact with the supporting member (210) is greater than the size of the first groove, specifically, the combined size of the circular areas of the plurality of first grooves.

In one example, the first fixing member (220) and the second fixing member (230) may be laminated in parallel along the thickness direction. Through this, the connecting pin (240) may be fixed to a position to be described below. That is, the first fixing member (220) and the second fixing member may be provided to face each other with the supporting member (210) interposed therebetween. That is, they may be vertically provided in up and down positions. At this time, the connecting pin (240) may be formed in a straight line to penetrate the supporting member (210), and both ends may be fixed and coupled to the first fixing member (220) and the second fixing member (230), respectively.

Therefore, preferably, the first fixing member (220) and the second fixing member (230) are always fixed to the supporting member (210), and their positions are also fixed.

The connecting pin (240) is a member for energizing the first wire harness part (300) and the second wire harness part (400), specifically, the second connector (320) of the first wire harness part (300) and the third connector (410) of the second wire harness part (400), which is disposed to pass through the first fixing member (220), the supporting member (210), and the second fixing member (230) sequentially. As the fixing part (200) comprises the connecting pin (240), the flowage of the first wire harness part (300) is suppressed, whereby the automatic charge and discharge inspection is possible through labor saving, and thus the work time may be shortened.

In one example, the connecting pin (240) may extend in the laminating direction of the first fixing member (220), the supporting member (210), and the second fixing member (230), and the extension length (l) of the connecting pin (240) may be greater than the total (t) of the thicknesses of the first fixing member (220), the supporting member (210), and the second fixing member (230). That is, the connecting pin (240) may have a pin shape in which the extension length is formed in a straight line. As the length (l) in the longitudinal direction is greater than the total (t) of the thicknesses of the first fixing member (220), the supporting member (210), and the second fixing member (230), the connecting pin (240) may be inserted into the second connector (320) and the third connector (410), respectively, by passing through the fixing member (220), the supporting member (210), and the second fixing member (230), and thus the flowage of the first wire harness (300) is suppressed, whereby the automatic charge and discharge inspection is possible through labor saving, and thus the work time may be shortened. In this specification, the term "thickness" means the length in the height direction. In this specification, the term "extends in the longitudinal direction" means a form in which the connecting pin is formed long along the longitudinal direction.

In addition, there may be a plurality of connecting pins (240), where the upper limit thereof is not particularly limited.

For the charge and discharge inspection, the battery module (100) must be electrically connected to the charge and discharge inspection part (500). Conventionally, this connection has been performed manually.

According to this example, the charge and discharge inspection part (500) may be provided to be connected to the second wire harness part (400). The second wire harness part (400) may be connected to the second fixing member (230).

The second wire harness part (400) is a cable for electrically connecting between the connecting pin (240) of the fixing part (200) and the charge and discharge inspection part (500), which may comprise the above-described third connector (410), a position adjusting part (420) and a second connection part (430).

The third connector (410) is a connection instrument for electrically connecting the connecting pin (240) disposed to pass through the second fixing member (230) and the second connection part (430), which is connected to one end of the second connection part (430) to be connected to the connecting pin (240) disposed to pass through the second fixing member (230) of the fixing part (200).

The position adjusting part (420) is a part that adjusts the position of the third connector (410) through reciprocating motion, which moves the third connector (410) toward the connecting pin (240) supporting the third connector (410) and disposed to pass through the second fixing member (230). The position adjusting part (420) may insert the third connector (410) into the connecting pin (240) disposed to pass through the second fixing member (230) through the above-described driving, or separate it therefrom. For example, a cylinder may be used as the position adjusting part. That is, electrical connection between the charge and discharge inspection part (500) and the supporting member (210) may be automatically performed through driving of the position adjusting part (420). In addition, electrical connection between the supporting member (210) and the battery module (100) may be performed in a previous process, that is, a coupling process. Therefore, in the charge and discharge inspection process, only the automatic connection between the charge and discharge inspection part (500) and the supporting member (210) is performed, whereby consequently, the electrical connection between the charge and discharge inspection part (500) and the battery module (100) can be performed effectively and stably.

The second connection part (430) is a part connecting the third connector (410) and the charge and discharge inspection part (500), wherein one end passes through the position adjusting part (420) to be connected to the third connector (410), and the other end is connected to the charge and discharge inspection part (500).

In one example, the second connection part (430) may have ductility. As the second connection part (430) has ductility, there may be an inconsistency that the operator has to manually connect the third connector (410) and the charge and discharge inspection part (500), but the third connector (410) is fixed by the fixing part (200), specifically, the connecting pin (240) and the flowage is suppressed, whereby the automatic charge and discharge inspection is possible through labor saving, and thus the work time may be shortened.

The charge and discharge inspection part (500) is an inspection device for identifying the charge and discharge performance of the battery module in an activation process when manufacturing the battery module, which is electrically connected to the second wire harness part (400), specifically, the second connection part (430). Through this, the flowage of the first wire harness part (300) is suppressed, whereby the automatic charge and discharge inspection is possible through labor saving, and the work time may be shortened.

In one example, the charge and discharge inspection part (500) may be electrically connected to the insertion part (120) of the battery module (100) to perform charging or discharging. Specifically, the charge and discharge inspection part (500) may be electrically connected to the insertion part (120) of the battery module (100) through the first wire harness part (300), the connecting pin (240) of the fixing part (200), and the second wire harness part (400). Through this, the flowage of the first wire harness part (300) is suppressed, whereby the automatic charge and discharge inspection is possible through labor saving, and the work time may be shortened.

According to this example, the current applying part (600) may be provided separately from the charge and discharge inspection part (500). The current applying part (600) applies a current to the battery module (100), which may be provided to contact the terminal block (110). That is, in the charge and discharge inspection process, the current applying part (600) may control the current application to induce charging and discharging of the battery module, and may inspect whether or not the battery module is normal through voltage and current value changes of charging and discharging in the charge and discharge inspection part (500), insulation resistance and withstand voltage testing and battery temperature monitoring, and the like.

In one example, the current applying part (600) may be electrically connected to the terminal block of the battery module (100) to apply the current. Figure 5 is a diagram exemplarily shown to explain a process of contacting a current applying part to a terminal block according to one example of the present invention.

As shown in Figure 5, as the current applying part (600) has two probes (610), and contacts the respective probes (610) to the positive electrode (+) and the negative electrode (-) of the terminal block (110), respectively to be electrically connected, it is possible to apply a current for performing charging or discharging of the battery module (100) thereto. Through this, it is possible to confirm whether charging for applying the current to the battery module (100) and discharging for discharging the current are normal through the charge and discharge inspection part.

Meanwhile, in one example of the present invention, the position of the second fixing member (230) in the fixing part (210) is fixed. Then, while the second fixing member (230) and the second wire harness (400) are coupled, the position of the second fixing member (230) is also fixed. Therefore, the coupling and uncoupling of the second fixing member (230) and the second wire harness (400), that is, the connection of the charge inspection part (500) and the battery module (100) in the inspection process may be automatically performed.

Meanwhile, in one example of the present invention, the battery module (100) may be stably seated on the supporting member (210) by its own weight. The electrodes formed on the terminal block of the battery module (100) may be exposed upward. Therefore, the probe (610) of the current applying part (600) may be automatically connected to the electrode, or disconnected therefrom. This is because the electrical connection between the probe and the electrode does not require a mechanical coupling such as engagement. This is a matter that the probe (610) moves to the top of the electrode to contact the electrode, which is because the electrical connection of both is sufficient. Therefore, the electrical connection between the current applying part (600) and the battery module (500) may also be automatically performed within the inspection process.

After all, according to the present example, in the charge and discharge inspection process, the inspection is automatically performed without the need for an operator to perform the inspection manually, so that a stable and efficient charge and discharge inspection can be performed.

### Industrial Applicability

It is described in the Detailed Description of Invention.

## Claims

1. A battery module charge and discharge inspection system, comprising:
a supporting member configured to support a battery module and transfer the battery module;
a first fixing member provided on a top of one side of the supporting member;
a second fixing member provided at a bottom of one side of the supporting member;
a connecting pin disposed to pass through the first fixing member, the supporting member, and the second fixing member, respectively; and
a charge and discharge inspection part configured to inspect whether or not the battery module is abnormal through charging and discharging of the battery module,
wherein the first fixing member is configured to be connected to a first wire harness extending from the battery module, and
wherein the second fixing member is configured to be connected to a second wire harness extending from the charge and discharge inspection part.

2. The battery module charge and discharge inspection system according to claim 1, wherein the first fixing member and the second fixing member are provided so as to face each other vertically in a thickness direction of the supporting member.

3. The battery module charge and discharge inspection system according to claim 1, wherein the connecting pin extends along a laminating direction of the first fixing member, the supporting member, and the second fixing member, and
wherein an extension length of the connecting pin is greater than a total combined thickness of the first fixing member, the supporting member, and the second fixing member.

4. The battery module charge and discharge inspection system according to claim 1, further comprising a current applying part configured to apply a current while being in contact with a terminal block of the battery module.

5. The battery module charge and discharge inspection system according to claim 4, wherein the terminal block comprises a positive electrode and a negative electrode.

6. The battery module charge and discharge inspection system according to claim 4, wherein a connection between the current applying part and the terminal block and a connection between the second fixing member and the charge and discharge inspection part are automatically performed.

7. The battery module charge and discharge inspection system according to claim 1, further comprising a plurality of battery cells.

8. The battery module charge and discharge inspection system according to claim 7, wherein the battery cell is a secondary battery.

9. The battery module charge and discharge inspection system according to claim 1, wherein the first wire harness comprises:
a first connector inserted into an insertion part of the battery module;
a second connector coupled to the first fixing member and configured to be electrically connected to the connecting pin; and
a first connection part configured to connect the first connector and the second connector.

10. The battery module charge and discharge inspection system according to claim 9, wherein the first connection part is ductile.

11. A battery module charge and discharge inspection method, comprising:
a coupling process of forming a first wire harness and connecting a battery module seated in a fixing part and the first wire harness; and
an inspection process of performing a charge and discharge inspection of the battery module transferred through the fixing part,
wherein the fixing part comprises:
a supporting member configured to support the battery module and transfer the battery module,
a first fixing member provided on a top of one side of the supporting member,
a second fixing member provided at a bottom of one side of the supporting member, and
a connecting pin disposed to pass through the first fixing member, the supporting member, and the second fixing member, respectively,
wherein the first fixing member in the coupling process is connected to the first wire harness extending from the battery module, and
wherein the second fixing member in the inspection process is connected to a charge and discharge inspection part.

12. The battery module charge and discharge inspection method according to claim 11, wherein a second wire harness extending from the charge and discharge inspection part is included, and
wherein the second fixing member is coupled to the second wire harness in the inspection process.

13. The battery module charge and discharge inspection method according to claim 11, wherein the first wire harness comprises a first connection part that is ductile,
wherein a connection between the first wire harness and the first fixing member in the coupling process is manually performed, and
wherein a connection between the charge and discharge inspection part and the second fixing member in the inspection process is automatically performed.

14. The battery module charge and discharge inspection method according to claim 13, wherein in the inspection process, a current is applied to the battery module by connecting a current applying part to a terminal block of the battery module.

15. The battery module charge and discharge inspection method according to claim 14, wherein in the inspection process, a connection between the terminal block and the current applying part is automatically performed.

16. A pallet for manufacturing a secondary battery, for supporting a secondary battery module and provided to transfer a battery module between processes, the pallet comprising:
a supporting member configured to support the battery module;
a first fixing member provided on a top of one side of the supporting member;
a second fixing member provided at a bottom of one side of the supporting member; and
a connecting pin disposed to pass through the first fixing member, the supporting member, and the second fixing member, respectively,
wherein in a coupling process in which a first wire harness is formed and coupled, the first fixing member is configured to be connected to the first wire harness extending from the battery module, and
wherein in a charge and discharge inspection process performed after the coupling process, the second fixing member is configured to be connected to a second wire harness extending from a charge and discharge inspection part.
